# EUROPÄISCHE PATENTSCHRIFT

(11) **EP 3 252 484 B1**
(45) Veröffentlichungstag und Bekanntmachung des Hinweises auf die Patenterteilung: **19.10.2022**
(21) Anmeldenummer: 17167668.7
(22) Anmeldetag: 24.04.2017
(51) Int. Cl.: G01R 31/12, H02H 1/00

(54) **VERFAHREN UND VORRICHTUNG ZUR FEHLERLICHTBOGEN-ERKENNUNG IN EINEM UNGEERDETEN STROMVERSORGUNGSSYSTEM**
METHOD AND DEVICE FOR DETECTING OF ELECTRIC ARC FAULTS IN AN UNEARTHED POWER SUPPLY SYSTEM
PROCÉDÉ ET DISPOSITIF DE DÉTECTION D'ARC DE COUPURE DANS UN SYSTÈME D'ALIMENTATION EN COURANT NON MIS À LA TERRE

(30) Priorität: 13.05.2016 DE 102016208322
(43) Veröffentlichungstag der Anmeldung: 06.12.2017
(73) Patentinhaber: Bender GmbH & Co. KG, 35305 Grünberg (DE)
(72) Erfinder: BRÖCKMANN, Eckhard, 35396 Gießen (DE); HACKL, Dieter, 35463 Fernwald (DE)
(74) Vertreter: advotec.

(56) Entgegenhaltungen:
- EP-A1- 2 717 063
- EP-A1- 2 777 581
- EP-A1- 2 919 026
- EP-A2- 2 778 703
- DE-A1- 2 002 777
- DE-A1- 19 633 527
- DE-T2- 69 414 328
- KR-B1- 101 341 107
- US-A- 5 602 709
- US-A1- 2012 176 712
- IAN A. FINNERAN ET AL: "A direct digital synthesis chirped pulse Fourier transform microwave spectrometer", REVIEW OF SCIENTIFIC INSTRUMENTS., Bd. 84, Nr. 8, 1. August 2013 (2013-08-01) , Seite 083104, XP055415818, US ISSN: 0034-6748, DOI: 10.1063/1.4818137
- ZHAO DONGSHENG ET AL: "Design and implementation of conducted emission reference source", 2014 IEEE INTERNATIONAL SYMPOSIUM ON ELECTROMAGNETIC COMPATIBILITY (EMC), IEEE, 4. August 2014 (2014-08-04), Seiten 12-17, XP032686796, DOI: 10.1109/ISEMC.2014.6898934 ISBN: 978-1-4799-5544-2 [gefunden am 2014-09-15]

## Beschreibung

Die Erfindung betrifft ein Verfahren und eine Vorrichtung zur Fehlerlichtbogen-Erkennung in einem ungeerdeten Stromversorgungssystem.

Lichtbögen treten als eine unerwünschte stromführende Gasentladung zwischen leitfähigen Teilen in elektrischen Anlagen auf, beispielsweise als Folge von nicht-fachgerechten Installationen oder infolge beschädigter Leitungsisolierungen. Die an der Störstelle auftretende Temperaturerhöhung kann in Verbindung mit brennbaren Materialien eine Ursache für gefährliche Brände bilden.

Eine frühzeitige Erkennung derartiger Fehler- oder Störlichtbögen erscheint daher dringend geboten, um weitere Schäden an der elektrischen Anlage zu vermeiden und eine Brandgefährdung auszuschließen.

In der Norm DIN EN 62606 (VDE 0665-10)/IEC 62606:2013 werden allgemeine Anforderungen an Fehlerlichtbogen-Schutzeinrichtungen (Arc Fault Detection Devices - AFDD) festgelegt. Aus der US-Prüfnorm UL 1699B folgen Anforderungen und Prüfvorgaben für Lichtbogendetektoren (Arc Fault Circuit Interrupters - AFCI) in Fotovoltaik-Anlagen, die vorrangig auf dem US-amerikanischen Markt zum Einsatz gelangen.

Das Funktionsprinzip dieser Schutzeinrichtungen und Detektoren basiert zumeist auf der frequenzselektiven Bewertung von Differenz- und/oder Lastströmen. Bei dieser leitungsgebundenen Fehlerlichtbogen-Erkennung wird der Strom auf dem zu überwachenden Leiter mittels eines Stromsensors (Messstromwandler) erfasst und mit Methoden der digitalen Signalverarbeitung im Spektralbereich ausgewertet. Charakteristische spektrale Verläufe des erfassten Stroms, die bei Zündung eines Lichtbogens auftreten, können so erkannt werden.

Allerdings verlangt eine zuverlässige Erkennung eines Lichtbogens recht aufwändige Signalverarbeitungsalgorithmen, da die mit der Entstehung eines Lichtbogens verbundenen charakteristischen spektralen Muster im normalen betriebsbedingten Rauschspektrum des erfassten Stroms verborgen sind. Insbesondere wenn weitere elektrische Komponenten, wie beispielsweise Frequenzumrichter mit einem recht breitbandigen Störspektrum in dem Stromversorgungssystem installiert sind, stellt sich die Erkennung des Lichtbogens schwierig dar.

In der EP 2 040 348 A2 sind ein Verfahren und eine Anordnung zur Erkennung von Lichtbögen beschrieben, die auf der beschriebenen Erfassung eines Leiterstroms mit einem Stromsensor und einer anschließenden digitalen Frequenzanalyse beruhen. Mittels FourierTransformation werden die Pegel des Gleichstromanteils und einzelner Harmonischer berechnet und bewertet. Dabei dient bei einem Wechselstromsystem die Netzfrequenz als Bezugsfrequenz für die aus einer PLL (Phase Locked Loop) erzeugte Abtastrate der digitalen Schaltung. Diese Abtastrate ist stets ein ganzzahliges Vielfaches der Netzfrequenz und kann sich bei einer Drift der Netzfrequenz kontinuierlich verändern.

Darüber hinaus ist der mit einer PLL einstellbare Bereich der Arbeitsfrequenzen begrenzt, sodass die Erzeugung höherer Harmonischer der Arbeitsfrequenz nicht realisierbar erscheint. Zudem ist die PLL-Regelung mit einer Trägheit verbunden, sodass das dynamische Verhalten bei schnellen Frequenzänderungen unbefriedigend bleibt.

Als weiterer Nachteil bei den vorgenannten Methoden der Fehlerlichtbogen-Erkennung erweist sich die schmalbandige Übertragungsfunktion der Messstromwandler, da, insbesondere Stromsensoren mit ferromagnetischen Kernen, prinzipbedingt nicht breitbandig arbeiten. Insoweit ist auch die auf dem erfassten Stromsignal beruhende Spektralanalyse bandbegrenzt und höherfrequente Spektralanteile, die zu einer zuverlässigeren Entscheidung über das Auftreten eines Lichtbogens führen könnten, müssen unberücksichtigt bleiben.

In Verbindung mit dem Betrieb von Umrichtern, deren typische Arbeitsfrequenzen (Umrichterschaltfrequenzen) im kHz-Bereich bei circa 10 kHz liegen, ist eine Betrachtung der Auswirkungen von Lichtbogenerscheinungen bei höheren Harmonischen der Arbeitsfrequenz im kHz-Frequenzbereich bis beispielsweise 110 kHz (11. Harmonische einer Arbeitsfrequenz von 10 kHz) sinnvoll.

Aufgrund der weiten Verbreitung geerdeter Stromversorgungssysteme sind bei der Entwicklung und Implementierung von Fehlerlichtbogen-Schutzeinrichtungen vor allem die Eigenschaften geerdeter Stromversorgungssysteme berücksichtigt worden. Die besonderen Eigenschaften von ungeerdeten Stromversorgungssystemen und die daraus resultierenden Möglichkeiten wurden bislang nicht genutzt.

Das ungeerdete Stromversorgungssystem - auch als isoliertes Netz (frz. Isolé Terre - IT) oder IT-Stromversorgungssystem bezeichnet - zeichnet sich dadurch aus, dass die aktiven Teile von dem Erdpotenzial - gegenüber Erde - getrennt sind. Der Vorteil dieser Netze liegt darin, dass bei einem ersten Isolationsfehler, wie beispielsweise einem Erdschluss oder einem Körperschluss, die Funktion der angeschlossenen elektrischen Betriebsmittel nicht beeinträchtigt wird, da sich wegen des im Idealfall unendlich großen Impedanzwertes zwischen den aktiven Leitern (Phasen und Neutralleiter) des Netzes und Erde in diesem ersten Fehlerfall kein geschlossener Stromkreis ausbilden kann, das ungeerdete Stromversorgungssystem daher auch bei einem ersten Fehler funktionstüchtig bleibt. US 2012/176712 A1, KR 101 341 107 B1, US 5 602 709 A, DE 694 14 328 T2, DE 196 33 527 A1 offenbaren weitere Verfahren und Vorrichtungen zur Erkennung von Lichtbögen. Weiterhin offenbart DE 20 02 777 A1 ein Verfahren und eine Vorrichtung zur Erkennung eines Körperschlusses.

Der vorliegenden Erfindung liegt somit die Aufgabe zugrunde, die Fehlerlichtbogen-Erkennung in ungeerdeten Stromversorgungssystemen, insbesondere in ungeerdeten Stromversorgungssystemen, die mit einem Frequenzumrichter ausgestattet sind, gegenüber den aus dem Stand der Technik bekannten Methoden zuverlässiger zu gestalten.

Diese Aufgabe wird durch ein Verfahren gemäß Anspruch 1 und eine Vorrichtung gemäß Anspruch 6 gelöst. Die abhängigen Ansprüche beinhalten vorteilhafte Weiterbildungen der Erfindung entsprechend der nachfolgenden Beschreibung dieser Maßnahmen.

Im Unterschied zu geerdeten Stromversorgungssystemen besteht in ungeerdeten Stromversorgungssystemen die Möglichkeit, in einem ersten Fehlerfall die Spannung gegen Erde an einem aktiven Leiter oder an einem Sternpunkt als Verlagerungsspannung zu erfassen.

Ein "einfacher" niederohmiger Isolationsfehler eines Leiters gegen Erde (Erdschluss) führt in einem ungeerdeten Stromversorgungssystem zu keinem nennenswerten Stromfluss. Somit liegt das elektrische Potential des fehlerhaften Leiters nahezu auf Erdpotential. Ist der niederohmige Isolationsfehler des Leiters gegen Erde jedoch durch einen Lichtbogen verursacht worden, so ist von einem nicht zu vernachlässigenden Stromfluss über den Lichtbogenwiderstand auszugehen. In diesem Fall entsteht auch ein (Verlagerungs-)Spannungsabfall an dem Lichtbogenwiderstand. In diesem Verlagerungsspannungssignal sind auch die für einen Lichtbogen charakteristischen Frequenzanteile enthalten.

Im Gegensatz zu der bandbegrenzten Erfassung des Stromsignals erfolgt die Erfassung des Verlagerungsspannungssignals sehr breitbandig und liefert damit die Grundlage für eine zuverlässige Entscheidung darüber, ob ein Fehlerlichtbogen aufgetreten ist.

Die Analyse des Frequenzspektrums der erfassten Verlagerungsspannung erfolgt durch Berechnen und Bewerten von Fourierkoeffizienten an den Stellen der Arbeitsfrequenz und deren Harmonischen über einen weiten Frequenzbereich.

Dazu wird der Wert einer in dem Stromversorgungssystem auftretenden Arbeitsfrequenz bereitgestellt. Die Bereitstellung der Arbeitsfrequenz ist erforderlich, um die Grundfrequenz (erste Harmonische) der orthogonalen, harmonischen Basisfunktionen zur Berechnung der Fourierkoeffizienten festzulegen.

Weiterhin ist die Arbeitsfrequenz eine Netzfrequenz des Stromversorgungssystems und/oder eine Umrichterschaltfrequenz eines Frequenzumrichters.

In einem reinen Wechselstromsystem ohne Frequenzumrichter entspricht die Arbeitsfrequenz der Netzfrequenz des Stromversorgungssystems. Ist in dem Stromversorgungssystem ein Frequenzumrichter installiert, beispielsweise in Verbindung mit einem geregelten elektrischen Antrieb, so entspricht die Arbeitsfrequenz der Umrichterschaltfrequenz und es treten Frequenzanteile an Stellen der Umrichterschaltfrequenz und deren höheren Harmonischen sowie möglicherweise ein Gleichanteil infolge eines DC-Zwischenkreises auf. Die vorliegende Erfindung ist daher gleichermaßen in ungeerdeten Wechselstromversorgungssystemen und in ungeerdeten Gleichstromversorgungssystemen, wie beispielsweise Fotovoltaikanlagen mit Wechselrichter, anwendbar.

In weiterer vorteilhafter Ausgestaltung erfolgt das Erzeugen von orthogonalen, harmonischen Basisfunktionen mit der Arbeitsfrequenz und deren Harmonischen mittels digitaler direkter Synthese (DDS) zur Berechnung der Fourierkoeffizienten.

Insbesondere bei elektrischen Anlagen, die mit einem Frequenzumrichter betrieben werden, ist eine schnelle Anpassung der in der Spektralanalyse zu betrachtenden Frequenzstellen an die augenblickliche Schaltfrequenz des Frequenzumrichters erforderlich.

Gegenüber einer PLL-basierten Regelung weist das DDS-generierte Signal - die harmonischen Basisfunktionen mit der Arbeitsfrequenz und deren Harmonischen - den Vorteil eines besseren dynamischen Verhaltens auf.

Damit können die erzeugten orthogonalen, harmonischen Basisfunktionen einer Frequenzänderung der Arbeitsfrequenz sehr rasch, und zwar mit stetigem Verlauf, folgen. Die Reaktion auf eine sprunghafte Frequenzänderung ist mit gewissen Abstrichen bei der Messgenauigkeit sogar während einer laufenden Integrationszeit der Berechnung der Fourierkoeffizienten möglich.

Die rein numerische Anpassung an die Arbeitsfrequenz durch die DDS-Generierung ermöglicht im Gegensatz zu einer regelungstechnischen Lösung darüber hinaus einen weiten spektralen Einstellbereich.

Unter Verwendung der so erzeugten orthogonalen, harmonischen Basisfunktionen werden in bekannter Weise die erfassten (Zeitbereichs-)Werte der Verlagerungsspannung nach der Umwandlung in ein zeit- und wertdiskretes Signal - durch Abtasten und Quantisieren - einer diskreten Fouriertransformation unterzogen.

In weiterer vorteilhafter Ausgestaltung erfolgt eine Entscheidung, dass ein Fehlerlichtbogen aufgetreten ist, falls mindestens ein normierter Fourierkoeffizient betragsmäßig einen dem jeweiligen normierten Fourierkoeffizienten zugeordneten Grenzwert überschreitet, wobei die Grenzwerte mit einem Faktor 1/n² bewertet werden, wobei n die Ordnung der n-ten Harmonischen der Arbeitsfrequenz ist.

Die Fourierkoeffizienten liegen als komplexwertige Koeffizienten mit Real- und Imaginärteil vor. Nach Betragsbildung und Normierung erfolgt eine Prüfung, ob der jeweilige normierte Fourierkoeffizient betragsmäßig den jeweiligen Grenzwert überschreitet.

Die Normierung erfolgt mittels Division des Betrags des jeweiligen Fourierkoeffizienten n-ter Ordnung durch den Betrag des Fourierkoeffizienten der ersten Harmonischen (Arbeitsfrequenz). Dadurch kann auf eine Absolut-Kalibrierung der Verstärkung des Gesamtsystems verzichtet werden und Schwankungen der Verstärkung werden ausgeglichen.

Mit dieser Maßnahme wird zum einen berücksichtigt, dass das Amplitudenspektrum einer Lichtbogenentladung näherungsweise durch eine 1/f-Charakteristik ähnlich dem Rosa Rauschen angenähert werden kann. Zum anderen erfolgt durch die Netzableitkondensatoren eine Integration des Stromsignals. Dieser Integration entspricht im Frequenzbereich eine zusätzliche Wichtung mit 1/f, sodass sich für die Festlegung der Grenzwerte bei der Auswertung der - durch den Stromfluss bewirkten - Verlagerungsspannung eine 1/n²-Abhängigkeit ergibt.

Durch die Auswertung einer Isolationswiderstandsmessung im Hinblick auf einen nieder- oder hochohmigen Isolationsfehler und/oder einen symmetrischen oder unsymmetrischen Isolationsfehler können aufbauend auf Erfahrungswerten Erkenntnisse über die Wahrscheinlichkeit des Auftretens eines Fehlerlichtbogens gewonnen werden.

Weiterhin werden weitere Netzparameter zur Fehlerlichtbogen-Erkennung mit herangezogen.

Weitere Netzparameter wie Netzspannung, Netzfrequenz oder Ableitkapazität werden ergänzend mitberücksichtigt, da sie mittelbar die erfasste Verlagerungsspannung beeinflussen.

Die Frequenzerfassung stellt den Wert der Arbeitsfrequenz bereit, der zur Erzeugung der orthogonalen, harmonischen Basisfunktionen an die Analyseeinrichtung übermittelt wird.

Die Frequenzerfassung ist so ausgelegt, dass bei einer Änderung der Arbeitsfrequenz die Bereitstellung der neuen Arbeitsfrequenz nach der Messung von genau einer Periode der neuen Arbeitsfrequenz erfolgt. Die Arbeitsfrequenz kann mittels einer als Frequenzmessgerät ausgeführten Frequenzerfassung aus einem Analogsignal gewonnen werden, das ein Abbild der auf dem Netz vorhandenen Spannungsverlaufs darstellt, oder bereits als digitales Taktsignal vorliegen, das unmittelbar die Arbeitsfrequenz repräsentiert.

Die Frequenzerfassung muss in der Lage sein, aus dem zugeführten Analogsignal, das ein Abbild des auf dem Netz vorhandenen Spannungsverlaufs ist, die darin enthaltene Arbeitsfrequenz zu extrahieren und der nachfolgenden Analyseeinrichtung zu übermitteln. Dabei kann die ermittelte Arbeitsfrequenz im Bereich von 50/60 Hz oder 400 Hz für Netzfrequenzen liegen und bis zu einer Größenordnung von 10 kHz bei Umrichterbetrieb reichen.

Weitere vorteilhafte Ausgestaltungsmerkmale ergeben sich aus der nachfolgenden Beschreibung und den Zeichnungen, die eine bevorzugte Ausführungsform der Erfindung an Hand von Beispielen erläutern. Es zeigen:
- **Fig. 1:**: eine Fehlerlichtbogen-Erfassung in einem ungeerdeten Stromversorgungssystem nach dem Stand der Technik,
- **Fig. 2:**: eine erfindungsgemäße Fehlerlichtbogen-Erfassung in einem ungeerdeten Stromversorgungssystem und
- **Fig. 3:**: eine erfindungsgemäße Vorrichtung zur Fehlerlichtbogen-Erkennung in einem ungeerdeten Stromversorgungssystem.

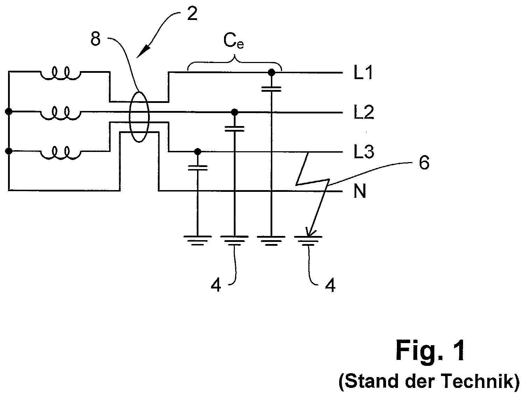

**Fig. 1** zeigt in einer schematischen Darstellung eine Fehlerlichtbogen-Erfassung in einem ungeerdeten Stromversorgungssystem 2 nach dem Stand der Technik. Das ungeerdete Stromversorgungssystem 2 ist beispielhaft als 3-phasiges Netz mit den aktiven Leitern L1, L2, L3 (Phasenleiter) und N (Neutralleiter) ausgeführt. Als besondere Eigenschaft des ungeerdeten Stromversorgungssystems 2 sind alle aktiven Teile des Stromversorgungssystems gegenüber Erde 4 getrennt, sodass sich bei einem ersten Isolationsfehler wegen des im Idealfall unendlich großen Impedanzwertes zwischen den aktiven Leitern L1, L2, L3, N des Stromversorgungssystems 2 und Erde 4 in diesem ersten Fehlerfall kein geschlossener Stromkreis ausbilden kann. In der Realität fließt ein äußerst geringer Ableitstrom, dessen Größe (in Wechselstromsystemen) in erster Linie durch die Netzableitkapazitäten Ce bestimmt ist.

Die Zündung eines Lichtbogens 6, beispielhaft zwischen dem Leiter L3 und Erde 4, bewirkt eine charakteristische impulsförmige Änderung des Leiterstroms, die mit einem Stromsensor 8 (Messstromwandler, Summenstromwandler) als Störereignis erkennbar ist. Diese Störung wird bei der Messung des Summenstroms durch die Ableitströme überlagert - sofern sich diese in Drehstromnetzen nicht gegenseitig aufheben sollten. Zudem besitzt der Stromsensor 8 nur eine begrenzte Übertragungsbandbreite. Auch mit aufwändigen Methoden der digitalen Signalverarbeitung im Spektralbereich kann die durch den Lichtbogen 6 verursachte Störung bislang nicht zuverlässig erkannt werden.

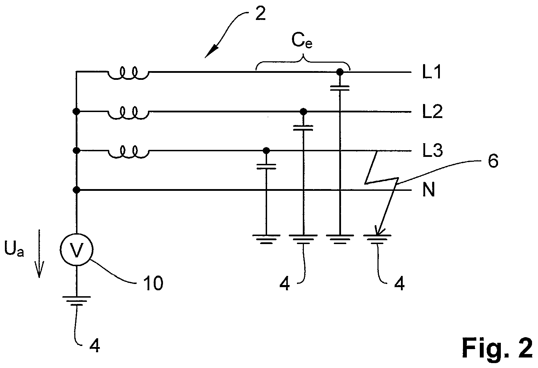

In **Fig. 2** ist in einer schematischen Darstellung eine erfindungsgemäße Fehlerlichtbogen-Erfassung in einem ungeerdeten Stromversorgungssystem dargestellt. Aufgrund der besonderen Eigenschaft des ungeerdeten Stromversorgungssystems 2 ist eine Verlagerungsspannung Ua mit einem Spannungssensor 10 messbar. In dem dargestellten Beispiel wird die Verlagerungsspannung Ua an dem Sternpunkt des Stromversorgungssystems 2 erfasst. Der durch Zündung des Lichtbogens 6 entstandene Isolationsfehler ist mit einem Stromfluss über den Lichtbogenwiderstand verbunden. Der Stromfluss führt an dem Lichtbogenwiderstand zu einem Spannungsabfall, der in Form der Verlagerungsspannung Ua messbar ist.

Im Gegensatz zu einer Erfassung des Stroms mit einem bandbreitenbegrenzten Stromsensor 8 kann die Erfassung der (Verlagerungs-)Spannung Ua mit einem als Spannungsmesseinrichtung ausgeführten Spannungssensor 10 in vorteilhafterweise sehr breitbandig erfolgen. Dies wiederum ermöglicht, auch höhere Harmonische der Arbeitsfrequenz in die spektrale Analyse miteinzubeziehen und so zu einer zuverlässigen Fehlerlichtbogen-Erkennung zu gelangen.

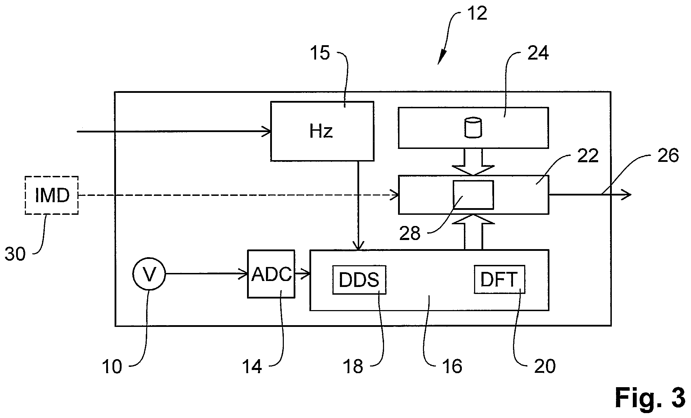

Die zur Spektraltransformation des Verlagerungsspannungs-Zeitsignals erforderliche Erzeugung der orthogonalen, harmonischen Basisfunktionen erfolgt durch einen DDS-Generator 18 (Fig. 3).

Die **Fig. 3** zeigt in einem funktionalen Blockdiagramm eine erfindungsgemäße Vorrichtung 12 zur Fehlerlichtbogen-Erkennung in einem ungeerdeten Stromversorgungssystem 2.

Die Vorrichtung 12 weist eingangsseitig den Spannungssensor 10 auf, der die Verlagerungsspannung Ua in dem Stromversorgungssystem 2 erfasst und an einen AD-Umsetzer 14 weiterleitet. Die Folge der abgetasteten und quantisierten Werte der Verlagerungsspannung Ua gelangen von dem Ausgang des AD-Umsetzers 14 in eine Analyseeinrichtung 16, in der diese Werte mittels einer diskreten Fourier-Transformation einer Spektralanalyse unterzogen werden.

Eine als Frequenzmessgerät ausgeführte Frequenzerfassung 15 ermittelt aus einem Analogsignal, das ein Abbild des auf dem Stromversorgungssystem 2 vorhandenen Spannungsverlaufs darstellt, den Wert der Arbeitsfrequenz und leitet diesen an die Analyseeinrichtung 16 weiter. Die Analyseeinrichtung 16 umfasst als wesentliche funktionale Einheiten den DDS-Generator 18 und einen DFT-Block 20.

Der DDS-Generator 18 erzeugt orthogonale, harmonische Basisfunktionen mit der bekannten Arbeitsfrequenz und deren Harmonischen. Diese Basisfunktionen werden in dem DFT-Block 20 zur Berechnung der Fourierkoeffizienten verwendet.

In einem Entscheider 22 werden die berechneten, normierten Fourierkoeffizienten mit den ihnen zugeordneten, in einem Speicher 24 abgelegten, gewichteten Grenzwerten verglichen. Der Entscheider 22 kann weiterhin eine Auswerteeinrichtung 28 aufweisen, die Ergebnisse einer Isolationswiderstandsmessung und/oder weitere Netzparameter mitberücksichtigt. Die Ergebnisse der Isolationswiderstandsmessung und/oder die weiteren Netzparameter können von einem Isolationsüberwachungsgerät (IMD) 30 geliefert werden.

Ist ein Auslösekriterium erfüllt, wird ein Alarmsignal 26 ausgegeben, das das Auftreten eines Lichtbogens 6 signalisiert.

Durch das Zusammenwirken der breitbandigen Erfassung der Verlagerungsspannung mit der "schnellen" Erzeugung der Basisfunktionen mittels des DDS-Generators kann eine zuverlässige Fehlerlichtbogen-Erkennung in einem ungeerdeten Stromversorgungssystem erreicht werden.

## Patentansprüche

1. Verfahren zur Fehlerlichtbogen-Erkennung in einem ungeerdeten Stromversorgungssystem (2), umfassend die Verfahrensschritte:
- Erfassen einer Verlagerungsspannung (Ua) gegen Erde (4) an einem aktiven Leiter (L1, L2, L3, N) oder an einem Sternpunkt des ungeerdeten Stromversorgungssystems (2),
- Bereitstellen eines Wertes einer in dem Stromversorgungssystem (2) auftretenden Arbeitsfrequenz,
- Analysieren eines Frequenzspektrums der erfassten Verlagerungsspannung (Ua) durch Berechnen und Bewerten von Fourierkoeffizienten an den Stellen der Arbeitsfrequenz und deren Harmonischen, wobei Ergebnisse einer Isolationswiderstandsmessung im Hinblick auf einen nieder- oder hochohmigen und/oder einen symmetrischen oder unsymmetrischen Isolationsfehler in einer gemeinsamen Auswertung mit der Spektralanalyse der Verlagerungsspannung zur Fehlerlichtbogen-Erkennung mit herangezogen werden und wobei entschieden wird, dass ein Fehlerlichtbogen (6) aufgetreten ist, falls mindestens ein normierter Fourierkoeffizient betragsmäßig einen dem jeweiligen normierten Fourierkoeffizienten zugeordneten Grenzwert überschreitet.

2. Verfahren nach Anspruch 1,
**dadurch gekennzeichnet,**
**dass** die Arbeitsfrequenz eine Netzfrequenz des Stromversorgungssystems (2) und/oder eine Umrichterschaltfrequenz eines Frequenzumrichters ist.

3. Verfahren nach Anspruch 1 oder 2,
**gekennzeichnet durch**
Erzeugen von orthogonalen, harmonischen Basisfunktionen mit der Arbeitsfrequenz und deren Harmonischen mittels digitaler direkter Synthese (DDS) zur Berechnung der Fourierkoeffizienten.

4. Verfahren nach einem der Ansprüche 1 bis 3,
**dadurch gekennzeichnet,**
**dass** die Grenzwerte mit einem Faktor 1/n² bewertet werden, wobei n die Ordnung der n-ten Harmonischen der Arbeitsfrequenz ist.

5. Verfahren nach einem der Ansprüche 1 bis 4,
**dadurch gekennzeichnet,**
**dass** weitere Netzparameter zur Fehlerlichtbogen-Erkennung mit herangezogen werden.

6. Vorrichtung zur Fehlerlichtbogen-Erkennung in einem ungeerdeten Stromversorgungssystem (2), mit einem Spannungssensor (10) zur Erfassung einer Verlagerungsspannung (Ua) gegen Erde (4) an einem aktiven Leiter (L1, L2, L3, N) oder an einem Sternpunkt des ungeerdeten Stromversorgungssystems (2), einer Frequenzerfassung (15) zur Bereitstellung eines Wertes einer in dem Stromversorgungssystem (2) auftretenden Arbeitsfrequenz, einer Analyseeinrichtung (16) zur Analyse eines Frequenzspektrums der erfassten Verlagerungsspannung (Ua) durch Berechnen von Fourierkoeffizienten an den Stellen der Arbeitsfrequenz und deren Harmonischen, einen Entscheider (22), der eingerichtet ist, um festzustellen, dass ein Fehlerlichtbogen (6) aufgetreten ist, falls mindestens ein normierter Fourierkoeffizient einen dem jeweiligen normierten Fourierkoeffizienten zugeordneten Grenzwert überschreitet, **dadurch gekennzeichnet, dass** der Entscheider (22) eine Auswerteeinrichtung (28) umfasst, die eingerichtet ist, um Ergebnisse einer Isolationswiderstandsmessung im Hinblick auf einen nieder- oder hochohmigen und/oder einen symmetrischen oder unsymmetrischen Isolationsfehler und/oder weitere Netzparameter in einer gemeinsamen Auswertung mit der Spektralanalyse der Verlagerungsspannung zur Fehlerlichtbogen-Erkennung mitzuberücksichtigen.

7. Vorrichtung nach Anspruch 6,
**dadurch gekennzeichnet,**
**dass** die Frequenzerfassung (15) so ausgeführt ist, dass die bereitgestellte Arbeitsfrequenz eine Netzfrequenz des Stromversorgungssystems (2) und/oder eine Umrichterschaltfrequenz eines Frequenzumrichters ist.

8. Vorrichtung nach Anspruch 6 oder 7,
**gekennzeichnet durch**
einen DDS-(direkte digitale Synthese)-Generator (18) zur Erzeugung von orthogonalen, harmonischen Basisfunktionen mit der Arbeitsfrequenz und deren Harmonischen zur Berechnung der Fourierkoeffizienten.

9. Vorrichtung nach Anspruch 6,
**gekennzeichnet durch**
eine Bewertungseinheit zur Bewertung der Grenzwerte mit einem Faktor 1/n², wobei n die Ordnung der n-ten Harmonischen der Arbeitsfrequenz ist.

## Claims

1. A method for identifying arc faults in an ungrounded power supply system (2), the method comprising the steps:
- detecting a displacement voltage (Ua) to ground (4) at an active conductor (L1, L2, L3, N) or at a neutral point of the ungrounded power supply system (2)
- providing a value of an operating frequency occurring in the power supply system (2),
- analyzing a frequency spectrum of the detected displacement voltage (Ua) by calculating and assessing Fourier coefficients at the locations of the operating frequency and its harmonics, results of an insulation resistance measurement also being taken into account in a shared evaluation with the spectral analysis of the displacement voltage with regards to a low-impedance or highimpedance and/or a symmetric or asymmetric insulation fault in order to identify arc faults and it being decided that an arc fault (6) has occurred, should at least one normalized Fourier coefficient, in terms of magnitude, exceed a threshold value allocated to the corresponding normalized Fourier coefficient.

2. The method according to claim 1,
**characterized in that**
the operating frequency is a power frequency of the power supply system (2) and/or a converter switching frequency of a frequency converter.

3. The method according to claim 1 or 2,
**characterized by**
generating orthogonal and harmonic basic functions using the operating frequency and its harmonics by means of direct digital synthesis (DDS) for calculating the Fourier coefficients.

4. The method according to any one of the claims 1 to 3, **characterized in that**
the threshold values are assessed using a factor of 1/*n*², wherein n is the order of the nth harmonic of the operating frequency.

5. The method according to any one of the claims 1 to 4, **characterized in that**
further system parameters are also taken into account for identifying arc faults.

6. A device for identifying arc faults in an ungrounded power supply system (2), the device comprising: a voltage sensor (10) for detecting a displacement voltage (Ua) to ground (4) at an active conductor (L1, L2, L3, N) or at a neutral point of the ungrounded power supply system (2); a frequency detection (15) for providing a value of an operating frequency occurring in the power supply system (2); an analyzing device (16) for analyzing a frequency spectrum of the detected displacement voltage (Ua) by calculating Fourier coefficients at the locations of the operating frequency and its harmonics; a decider (22), which is configured to determine that an arc fault (6) has occurred, should a normalized Fourier coefficient exceed a threshold value allocated to the corresponding Fourier coefficient,
**characterized in that**
the decider (22) comprises an evaluation device (28) which is configured to take into account results of an insulation resistance measurement in a shared evaluation with the spectral analysis of the displacement voltage with regards to a low-impedance or highimpedance and/or a symmetric or asymmetric insulation fault and/or other network parameters in order to identify arc faults.

7. The device according to claim 6,
**characterized in that**
the frequency detection (15) is realized in such a manner that the provided operating frequency is a power frequency of the power supply system (2) and/or a converter switching frequency of a frequency converter.

8. The device according to claim 6 or 7,
**characterized by**
a DDS generator (direct digital synthesis generator) (18) for generating orthogonal and harmonic basic functions using the operating frequency and its harmonics for calculating the Fourier coefficients.

9. The device according to claim 6,
**characterized by**
an assessing unit for assessing the threshold value having a factor of 1/*n*², wherein n is the order of the nth harmonic of the operating frequency.

## Revendications

1. Procédé pour l'identification des défauts d'arc dans un système (2) d'alimentation en énergie non mis à la terre, le procédé comprenant les étapes :
- détecter une tension de déplacement (Ua) à la terre (4) à un conducteur actif (L1, L2, L3, N) ou à un point neutre du système (2) d'alimentation en énergie non mis à la terre
- mettre à disposition une valeur d'une fréquence de fonctionnement se produisant dans le système (2) d'alimentation en énergie,
- analyser un spectre de fréquence de la tension de déplacement (Ua) détectée en comptant et en évaluant des coefficients de Fourier aux endroits de la fréquence de fonctionnement et ses composantes harmoniques, des résultats d'une mesure de résistance d'isolation étant pris en considération dans une évaluation commune avec l'analyse spectrale de la tension de déplacement au sujet d'un défaut d'isolation à basse impédance ou à haute impédance et/ou symétrique ou asymétrique afin d'identifier des défauts d'arc et une décision étant prise qu'un défaut d'arc (6) s'est produit si au moins un coefficient de Fourier normalisé, en termes de grandeur, surpasse une valeur de seuil associée au coefficient de Fourier normalisé correspondant.

2. Procédé selon la revendication 1,
**caractérisé en ce que**
la fréquence de fonctionnement est une fréquence du réseau de la système (2) d'alimentation en énergie et/ou une fréquence de commutation de convertisseur d'un convertisseur de fréquence.

3. Procédé selon la revendication 1 ou 2,
**caractérisé par**
générer des fonctions fondamentales harmoniques orthogonales en utilisant la fréquence de fonctionnement et ses composantes harmoniques au moyen de la synthèse numérique directe (anglais : *direct digital synthesis,* DDS) afin de compter les coefficients de Fourier.

4. Procédé selon l'une quelconque des revendications 1 à 3, **caractérisé en ce que**
les valeurs de seuil sont évaluées en utilisant un facteur de 1/*n*², dans lequel *n* est l'ordre de nième composante harmonique de la fréquence de fonctionnement.

5. Procédé selon l'une quelconque des revendications 1 à 4, **caractérisé en ce**
**qu'**autre paramètres du réseau sont pris en considération afin d'identifier des défaut d'arc.

6. Dispositif pour l'identification des défauts d'arc dans un système (2) d'alimentation en énergie non mis à la terre, le dispositif comprenant : un capteur de tension (10) pour détecter une tension de déplacement (Ua) à la terre (4) à un conducteur actif (L1, L2, L3, N) ou à un point neutre du système (2) d'alimentation en énergie non mis à la terre ; une détection de fréquence (15) pour mettre à disposition une valeur d'une fréquence de fonctionnement se produisant dans le système (2) d'alimentation en énergie ; un dispositif d'évaluation (16) pour évaluer un spectre de fréquence de la tension de déplacement (Ua) détectée en comptant des coefficients de Fourier aux endroits de la fréquence de fonctionnement et ses composantes harmoniques ; un décideur (22), qui est configuré pour déterminer qu'un défaut d'arc (6) s'est produit si un coefficient de Fourier normalisé dépasse une valeur de seuil associée au coefficient de Fourier correspondant,
**caractérisé en ce que**
le décideur (22) comprend un dispositif d'évaluation (28) qui est configuré pour prendre en considération des résultats d'une mesure de résistance d'isolation dans une évaluation commune avec une analyse spectrale de la tension de déplacement au sujet d'un défaut d'isolation à basse impédance ou à haute impédance et/ou symétrique ou asymétrique afin d'identifier des défaut d'arc.

7. Dispositif selon la revendication 6,
**caractérisé en ce que**
la détection de fréquence (15) est réalisée de telle manière que la fréquence de fonctionnement mise à disposition est une fréquence du réseau du système (2) d'alimentation en énergie et/ou une fréquence de commutation de convertisseur d'un convertisseur de fréquence.

8. Dispositif selon la revendication 6 ou 7,
**caractérisé par**
un générateur DDS (synthèse numérique directe) (18) pour générer des fonctions fondamentales orthogonales harmoniques en utilisant la fréquence de fonctionnement et ses composantes harmoniques afin de compter les coefficients de Fourier.

9. Dispositif selon la revendication 6,
**caractérisé par**
une unité d'évaluation pour évaluer la valeur de seuil ayant un facteur de 1/*n*², dans lequel n est l'ordre de nième composante harmonique de la fréquence de fonctionnement.
